# NEW EUROPEAN PATENT SPECIFICATION

(11) **EP 0 629 045 B2**
(45) Date of publication and mention of the opposition decision: **17.01.2007**
(45) Mention of the grant of the patent: 22.03.2000
(21) Application number: 94108580.5
(22) Date of filing: 04.06.1994
(51) Int. Cl.: H03J 5/02, H03J 1/00

(54) **Tuning device for a receiver of radioelectric signals with coils obtained by printing**
Abstimmeinrichtung für einen Radiowellenempfänger mit in Drucktechnik ausgeführten Wicklungen
Dispositif d'accord pour un récepteur de signaux radio-électriques aux bobines réalisées par circuits imprimés

(30) Priority: 07.06.1993 IT TO930405
(43) Date of publication of application: 14.12.1994
(73) Proprietor: EDICO S.r.l., 00196 Roma (IT)
(72) Inventor: Belisomi, Pietro, I-20010 Vittuone (MI) (IT); Cavallo, Salvatore, I-20100 Milano (IT); Carcone, Dante, I-20030 Senago (MI) (IT)
(74) Representative: Eisenführ, Speiser & Partner

(56) References cited:
- EP-A- 0 492 653
- EP-A- 0 540 908
- EP-B- 0 147 518
- DE-C2- 3 406 150
- GB-A- 2 187 906
- Funkschau 1996, Heft 10, pages 305-307; E. Stäbler, Gedruckte Spulen und Kondensatoren
- Taschenbuch Eletronik, Bd.3, Bauelemente und Bausteine der Informationstechnik, 3. Auflage, pages 274-277, Verlag Technik, Berlin, 1988

## Description

The present invention relates to a method of calibrating a tuner of a receiver of radioelectric signals; in particular for a television receiver, with a plurality of tuning circuits, each one including a varactor diode and coils obtained by way of a printing procedure, and to a television signal receiver using said calibrating method.

As known tuners for radioelectric signals, in particular those for receivers of television signals, which can also be, apart from televisions, video recorders and the like, traditionally comprise an amplifier stage and a converter stage, in turn constituted by a local oscillator and by a mixer that mixes the received signal with that locally generated, according to the classical superheterodyne system.

Said tuners usually provide 4 tuned circuits, three for the incoming signal and one for the signal locally generated.

Such circuits, so as to enable the tuning in an electrical way, each comprise as a capacitive element a so called varactor diode, the capacity of which varies in accordance with the voltage applied.

The tuning inductors on the other hand are traditionally obtained by way of coils, realised in copper wire windings in the form of a spiral spring, so as to enable their calibration by suitably deforming them by hand.

The calibration is necessary for enabling the tuning of each circuit, with a sufficient precision, on the entire range of each of the signal bands to be tuned; usually the calibration of each of the circuits is actually carried out on two points for every band.

The frequency synthesis tuners also require a calibration of the circuit of the local oscillator, as, even though the frequency synthesis system provides for generating the exact signal frequency, it is necessary that the corresponding voltage necessary for the respective varactor be comprised within the range of voltages provided, i.e. it is necessary that the tolerance on the inductor be comprised within tight values; the calibration must then take place on the other 3 circuits, so as to place them 'in step' with that of the local oscillator.

It is known from the British patent application 2 187 906 an electronic tuner for television receivers equipped with a memory in which information concerning voltages for selecting each channel is stored.

The document stresses that neither the selection of matched varactor diodes nor tracking is necessary, because the storing is made for each channel.

This method however, beside having an higher cost, suffers the drawback of being subject to possible deformation of the coils after the memorisation so rendering the performance very poor. From EP-B1-0147518 it is known a method and a television receiver having the features according to the preamble of claim 1 and, respectively, claim 11.

It is also known from European patent application n. 0 492 653 a printed filter for use in television tuners; the filter is equipped with a spiral coil in which at least one set of adjacent turns are electrically coupled through a short circuit line to be eventually cut in order to calibrate the coil.

This document uses printed coils, but with the intention to adjust them for calibrate the filter.

It is also known from EP-A-540 908 a method and apparatus for automatic tuning calibration of electronically tuned filters comprising a programmable frequency generator, a filter, a detector, a processor for programming the frequency generator and for producing a stepped filter tuning voltage and storing the detector voltage; calibration frequency signal versus tuning voltage responses are stored for a number of calibration iterations and the resulting table can be used to determine the correct tuning voltage for the filter.

The aim of the present invention is that of indicating a simple calibration method for a tuner of the described type, that does neither call for a manual calibration nor for iterations and that has better calibration characteristics and a greater stability than those obtained with the known calibration methods.

For reaching said aim the subject of the present invention is a calibration method for a tuner of radioelectric signals having the characteristics described in claim 1 and a television signal receiver having the characteristics described in claim 11.

Further characteristics and advantages of the present invention shall result in being clear from the following description and annexed drawings, supplied purely as an explanatory and non-limiting example, wherein:
- figure 1 schematically represents the block diagram of a tuner according to the invention;
- figure 2 represents the printed circuit board of the device of figure 1.

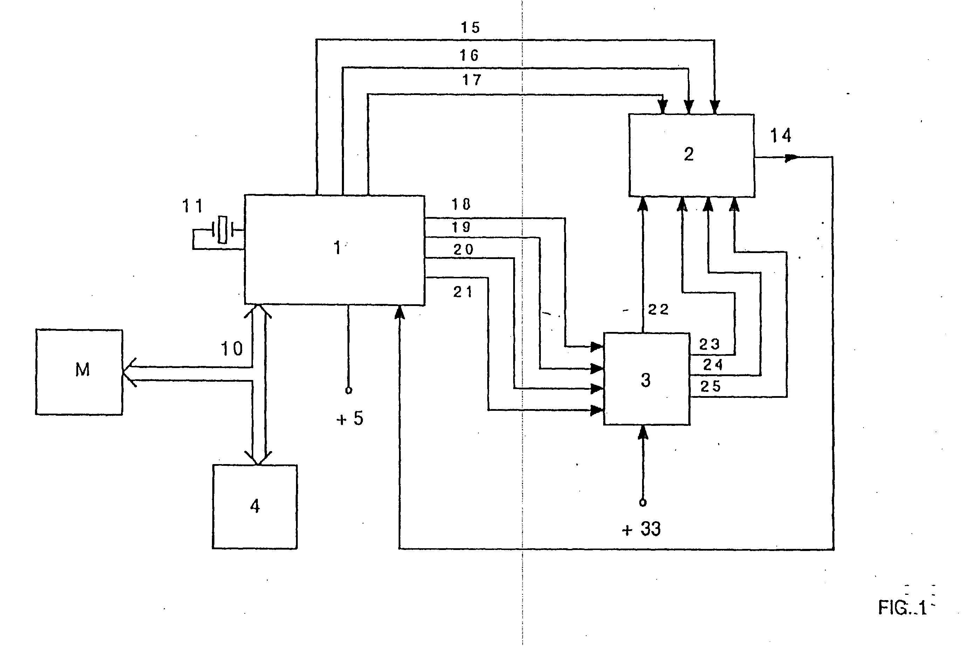

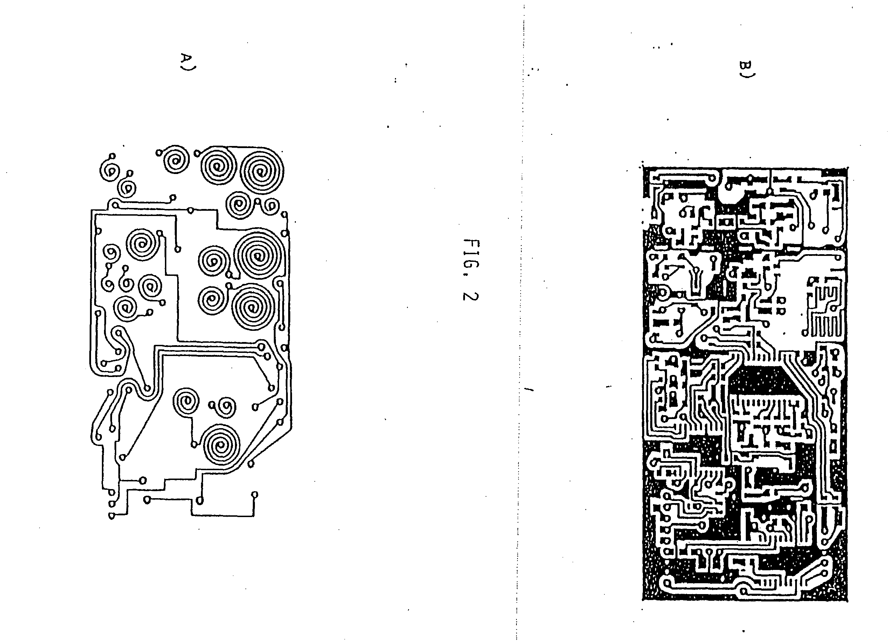

In figure 1 a block diagram of a tuner is represented according to the invention, applied to a receiver of television signals; in figure 1 reference number 1 indicates an integrated circuit that in the following shall be described more in detail; reference number 2 indicates the actual tuner, of a substantially traditional type, comprising 4 tunable circuits, three for the incoming signal and one for the local oscillator; each of the 4 circuits comprise at least one inductor, realised by printing on a printed circuit (see figure 2a), a varactor diode and other usual components; the circuit 2 also comprises the necessary active semiconductor elements, for example field effect transistors and integrated circuits.

Reference number 3 indicates a circuit that is substantially an amplifier of the control voltages for the varactor diodes; said voltages come from the integrated circuit 1 (wires 18,19, 20,21) and are supplied amplified to the circuit 2 (wires 22,23,24,25); more precisely the wire 22 supplies the voltage to the varactor of the local oscillator, while the other 3 wires supply the tuning voltages to the 3 varactor of the signal input circuits.

Reference number 14 indicates the output of the local oscillator, that comes from circuit 2 to circuit 3; reference numbers 15, 16, 17 indicate the band information for the circuit 2 and come from the integrated circuit 1; reference number 11 indicates the quartz that generates the clock signal for the circuit 1.

Reference number 10 indicates the command bus for the circuit 1; said bus can be for instance of the known 12C type; finally with symbols +5 and +33 two supply voltages are indicated, respectively of 5 and 33 volt.

The integrated circuit 1 substantially comprises the elements of a traditional frequency synthesis tuning circuit programmable divider and PLL phase comparator (Phase Locked Loop); this is controlled by a microprocessor control unit (indicated with reference number 4) by way of bus 10.

Moreover the circuit 1 also supplies the three tuning voltages for the varactor of the input circuits, by way of the wires 19,20,21. The control unit 4 is in turn connected by way of the bus to a non volatile type memory (indicated with the reference letter M).

The three tuning voltages for the varactor of the input circuits are produced starting from digital information stored in the memory M; such digital information corresponds to the differential corrections to furnish to the voltages of the varactor of the local oscillator, and are translated as voltage values by way of three D/A converters.

In figure 2 the two sides of the printed circuit of the tuner according to the invention are indicated; in figure 2a the inductors obtained with the printing procedure are clearly visible; in figure 2b the other side is represented with the connections of the components, on which almost all of the components are of the SMD type (Surface Mounted Devices).

As is seen the inductors are realised in a round spiral form; it is in fact understood that this form is preferable to that for example of a squared spiral, be it for its residual capacity and as its Q value.

Given the tight tolerance with which said inductors can be obtained due to the printing procedure, it is possible to avoid the specific calibration of the local oscillator and is limited to that of the three input tuning circuits.

The functioning of the tuner represented in figure 1 is the following.

The tuner 2 is dimensioned in production so as that, applying to the 4 varactor the same voltage (for instance 1,5 volt) the local oscillator (for instance in the UHF band) generates the corrected oscillator voltage for receiving the first channel of the band (channel 21), and that the three input circuits are tuned as better as possible to the central frequency of the same channel; this is obtained, in a known way, with an appropriate dimensioning of the inductors and of the series capacitors. Furthermore the design will provide that, with a voltage applied to the 4 varactor of 25 volt the frequency of the local oscillator is correct for the last channel of the band (channel 69), and that the three input circuits are tuned as better as possible to the central frequency of the same channel;this by always appropriately dimensioning the inductors and the residual capacities.

At this point every tuner is individually calibrated in a suitable number of points for each band; let's assume, as an example, on 10 channels (in the UHF band), and precisely on channels 22, 27, 32, 37, 42, 47, 52, 57, 62, 67. The calibration is carried out by supplying the corrected oscillator voltage, by way of the PLL circuit, and varying each of the 3 varactor voltage values of the input circuits by a certain amount (for instance 3 volt) higher or lower than the voltage of the oscillator; the maximum.response is searched; for instance at the centre of the band, and the necessary correction is stored in the memory M. The calibration can be automatically carried out by an apparatus that tunes the established channels, carries out the voltage variations and stores the three individual corrections for that channel.

The procedure is repeated for every band and the tuner is ready; in reception the microprocessor 4 will naturally provide for reading in the memory M, channel for channel, the correction values of the voltages and to send the relative instructions to the circuit 1. For the intermediate channels from those calibrated the correction value for the nearest channel can be simply taken; alternately an interpolation of values starting from the corrections stored for the two nearest channel can be carried out.

It is however clear that the calibration will result in being more precise than that traditionally carried out on only 2 channels per band.

Form the given description the characteristics of the method subject of the present invention result in being clear, as are also, clear its advantages.

In particular the method according to the invention allows to:
- automate the calibration, with a corresponding reduction in costs:

- obtain a far greater level of precision, be it for the number of calibration points that can be carried out, and for the elimination of errors due to manual execution.

It is clear that the inductors realised on the printed circuit are very advantageous for the tuning according to the invention; in fact while with traditional calibration systems they cannot be used, as it is not easy to vary in a fine manner their value, they are ideal for an automatic calibration that acts upon the differential values of the varactor voltages; in fact also the production tolerances of the printed circuits, for instance those leading to thinner or fatter conductors have little effect on the differential values (the inductors all result in being shifted in the same direction). It is also clear that use within the tuner of traditional coils would be useless and counterproductive.

Finally it is clear that numerous variants can be made to the method subject of the present invention, without for this departing from the principles of novelty inherent in the innovative idea, as is clear that in the practical realisation of the invention the materials or the components utilised, and the form of the illustrated details can be different, and can be substituted with technically equivalent elements.

For example it is possible, if desired, to execute the calibration on a number being less or greater than the channels of the given example.

It is possible for the calibration to take into consideration two points per channel (for instance corresponding to the frequency of the video carrier and of the audio carrier), as opposed to only the central point.

## Claims

1. Method of calibrating a tuner of a receiver of radioelectric signals, in particular for a television receiver, with a plurality of tuning circuits, one of them being part of a local oscillator, and each tuning circuit including a varactor diode and coils, according to which :
- the calibration is performed only on one channel every N channels by varying the tuning voltages supplied to the varactor diodes and without adjusting said coils, but only searching the best values of calibration voltages of said varied tuning voltages;
- appropriate information concerning the values of the calibration voltages are stored in a storage device which is associated with the tuner;
- the calibration is not provided for the tuning voltage to be applied to the varactor diode of the local oscillator circuit of the tuner,
- said stored information comprises differential values of the varied tuning voltages of the tuning circuits in respect of the values of the tuning voltage of the local oscillator circuit of the tuner,
**characterized in that**
N is a number greater than three, in particular five,
wherein said method is applied to a tuner in which said coils are obtained by way of a printing procedure, and all of said printed coils are comprised in the same printed circuit.

2. Calibrating method according to claim 1,
**characterized in that** said calibration is carried out correcting the voltages applied to said varactor diodes starting from said stored information, which is a digital information, converted by way of D/A converters.

3. Calibrating method according to claim 1 or 2,
**characterized in that** said calibration is carried out correcting the voltages applied to said varactor diodes so as to obtain a maximum signal response.

4. Calibrating method according to claim 3,
**characterized in that** said calibration is carried out so as to obtain a maximum signal response at the central frequency of the channel.

5. Calibrating method according to claim 3,
**characterized in that** said calibration is carried out so as to obtain a maximum signal response of the video carrier frequency of the channel.

6. Calibrating method according to claim 3,
**characterized in that** said calibration is carried out so as to obtain a compromise of the signal response of the video carrier frequency and of the audio carrier frequency of the channel.

7. Calibrating method according to one or more of the preceding claims,
**characterized in that**, during the tuning of a radioelectric signal to be received, said stored information in a digital type memory (M), is re-read and used for correcting the voltage applied to said varactor diodes.

8. Calibrating method according to one or more of the preceding claims,
**characterized in that**, during the tuning of a radioelectric signal to be received, said stored information in a digital type memory (M), is re-read and used for correcting the voltage applied to said varactor diodes and that for the channels for which the calibration has not been carried out the stored information for the nearest calibrated channel is employed.

9. Calibrating method according to one or more of the preceding claims, **characterized in that**, during the tuning of a radioelectric signal to be received, said stored information in a digital type memory (M), is re-read and used for correcting the voltage applied to said varactor diodes and that for the channels for which the calibration has not been carried out the stored information for the two nearest calibrated channel is interpolated.

10. Calibrating method according to one or more of the preceding claims, **characterized in that** the said storing of calibration information in a digital type memory (M) is carried out automatically.

11. Television signal receive including an electronic tuner with a plurality of tuning circuits, one of them being part of a local oscillator, and each tuning circuit including a varactor diode and coils, wherein:
- the calibration is performed only on one channel every N channels by varying the tuning voltages supplied to the varactor diodes and without adjusting said coils, but only searching the best values of calibration voltages of said varied tuning voltages;
- appropriate information concerning the values of the calibration voltages are stored in a storage device which is associated with the tuner;
- the calibration is not provided for the tuning voltage to be applied to the varactor diode of the local oscillator circuit of the tuner,
- said stored information comprises differential values of the varied tuning voltages of the tuning circuits in respect of the values of the tuning voltage of the local oscillator circuit of the tuner,
**characterized in that**
said coils are obtained by way of a printing procedure,
all of said printed coils are comprised in the same printed circuit, and
N is a number greater than three, in particular five.

12. Television signal receiver according to Claim 11,
**characterized in that** said printed coils are realized in the form of concentric round spirals.

## Patentansprüche

1. Verfahren zum Kalibrieren einer Abstimmeinrichtung eines Empfängers von radioelektrischen Signalen, insbesondere für einen Fernsehempfänger mit einer Vielzahl von Abstimmschaltungen, von denen eine Teil eines lokalen Oszillators ist und wobei jede Abstimmschaltung eine Kapazitätsdiode und Spulen einschließt, demgemäß
- die Durchführung der Kalibrierung lediglich für einen Kanal für alle N-Kanäle durchgeführt wird, indem die Abstimmspannungen, die an die Kapazitätsdioden angelegt werden, variiert werden, und ohne Justierung der Spulen, aber lediglich durch Suchen des besten Wertes für Kalibrierspannungen der variierten Abstimmspannungen;
- geeignete Informationen hinsichtlich der Werte der Kalibrierspannungen in einer Speichervorrichtung gespeichert werden, die der Abstimmvorrichtung zugeordnet ist;
- die Kalibrierung nicht vorgesehen ist für die Abstimmspannung, die an die Kapazitätsdiode der lokalen Oszillatorschaltung der Abstimmvorrichtung angelegt wird;
- die gespeicherten Informationen Differenzwerte der variierten Abstimmspannungen der Abstimmschaltungen hinsichtlich der Werte der Abstimmspannung der lokalen Oszillatorschaltung der Abstimmvorrichtung aufweisen;
**dadurch gekennzeichnet, dass** N eine Zahl größer als drei, insbesondere fünf ist, wobei das Verfahren auf eine Abstimmeinrichtung angewendet wird, in der die Spulen mittels eines Drucktechnikvorgangs erhalten werden und sämtliche der gedruckten Spulen in derselben gedruckten Schaltung enthalten sind.

2. Kalibrierverfahren nach Anspruch 1,
**dadurch gekennzeichnet, dass** die Kalibrierung durchgeführt wird, indem die an die Kapazitätsdioden angelegten Spannungen beginnend von den gespeicherten Informationen korrigiert werden, die mittels eines D/A-Wandlers umgewandelte digitale Informationen darstellen.

3. Kalibrierverfahren nach Anspruch 1 oder 2,
**dadurch gekennzeichnet, dass** die Kalibrierung durchgeführt wird, indem die an die Kapazitätsdioden angelegten Spannungen korrigiert werden, um eine maximale Signalantwort zu erhalten.

4. Kalibrierverfahren nach Anspruch 3,
**dadurch gekennzeichnet, dass** die Kalibrierung ausgeführt wird, um eine maximale Signalantwort an der Zentralfrequenz des Kanals zu erhalten.

5. Kalibrierverfahren nach Anspruch 3,
**dadurch gekennzeichnet, dass** die Kalibrierung ausgeführt wird, um eine maximale Signalantwort der Videoträgerfrequenz des Kanals zu erhalten.

6. Kalibrierverfahren nach Anspruch 3,
**dadurch gekennzeichnet, dass** die Kalibrierung ausgeführt wird, um einen Kompromiss zwischen der Signalantwort der Videoträgerfrequenz und der Audioträgerfrequenz des Kanals zu erhalten.

7. Kalibrierverfahren nach einem oder mehreren der vorherigen Ansprüche,
**dadurch gekennzeichnet, dass** während der Abstimmung eines zu empfangenen radioelektrischen Signals die gespeicherten Informationen in einem digitalen Speicher (M) wiedergelesen und zum Korrigieren der an die Kapazitätsdioden angelegte Spannung verwendet werden.

8. Kalibrierverfahren nach einem oder mehreren der vorherigen Ansprüche,
**dadurch gekennzeichnet, dass** die gespeicherten Informationen in einem digitalen Speicher (M) während der Abstimmung eines zu empfangenen radioelektrischen Signals wiedergelesen und zum Korrigieren der an die Kapazitätsdioden angelegte Spannung verwendet werden und dass für die Kanäle, für die die Kalibrierung noch nicht durchgeführt wurde, die Informationen von dem nächsten kalibrierten Kanal verwendet wird.

9. Kalibrierverfahren nach einem oder mehreren der vorherigen Ansprüche,
**dadurch gekennzeichnet, dass** die gespeicherten Informationen in einem digitalen Speicher (M) während der Abstimmung eines zu empfangenen radioelektrischen Signals wiedergelesen und zum Korrigieren der an die Kapazitätsdioden angelegte Spannung verwendet werden und dass für die Kanäle, für die die Kalibrierung noch nicht ausgeführt wurde, die gespeicherten Informationen der beiden nächsten kalibrierten Kanäle interpoliert werden.

10. Kalibrierverfahren nach einem oder mehreren der vorherigen Ansprüche,
**dadurch gekennzeichnet, dass** das Speichern von Kalibrierinformationen in einem digitalen Speicher (M) automatisch durchgeführt wird.

11. Fernsehsignalempfänger mit einer elektronischen Abstimmvorrichtung mit einer Vielzahl von Abstimmschaltungen, von denen eine Teil eines lokalen Oszillators ist und wobei jede Abstimmspannung eine Kapazitätsdiode und Spulen aufweist, wobei
- die Durchführung der Kalibrierung lediglich für einen Kanal für alle N-Kanäle durchgeführt wird, indem die Abstimmspannungen, die an die Kapazitätsdioden angelegt werden, variiert werden, und ohne Justierung der Spulen, aber lediglich durch Suchen des besten Wertes für Kalibrierspannungen der variierten Abstimmspannungen;
- geeignete Informationen hinsichtlich der Werte der Kalibrierspannungen in einer Speichervorrichtung gespeichert werden, die der Abstimmvorrichtung zugeordnet ist;
- die Kalibrierung nicht vorgesehen ist für die Abstimmspannung, die an die Kapazitätsdiode der lokalen Oszillatorschaltung der Abstimmvorrichtung angelegt wird;
- die gespeicherten Informationen Differenzwerte der variierten Abstimmspannungen der Abstimmschaltungen hinsichtlich der Werte der Abstimmspannung der lokalen Oszillatorschaltung der Abstimmvorrichtung aufweisen;
**dadurch gekennzeichnet, dass** die Spulen mittels eines Drucktechnikvorgangs erhalten werden, sämtliche der gedruckten Spulen in derselben gedruckten Schaltung enthalten sind und N eine Zahl größer als drei, insbesondere fünf ist.

12. Fernsehsignalempfänger nach Anspruch 11,
**dadurch gekennzeichnet, dass** die gedruckten Spulen in Form von konzentrischen runden Spiralen realisiert werden.

## Revendications

1. Procédé d'étalonnage d'un sélecteur de canaux d'un récepteur de signaux radioélectriques, en particulier d'un poste de télévision, présentant une pluralité de circuits de sélection ou d'accord, dont l'un fait partie d'un oscillateur local, chaque circuit d'accord comprenant une diode varactor et des bobines, :
- l'étalonnage est réalisé uniquement sur un canal tous les N canaux en variant les tensions d'accord fournies aux diodes varactor, et sans réglage desdites bobines, mais en cherchant uniquement les meilleures valeurs de tension d'étalonnage desdites tensions d'accord variées;
- l'information appropriée concernant les valeurs de tensions d'étalonnage est mise en mémoire dans un dispositif de stockage qui est associé au sélecteur de canaux ;
- l'étalonnage n'est pas fourni pour les tensions d'accord à fournir aux diodes varactor du circuit d'oscillateur local du sélecteur de canaux,
- ladite information mise en mémoire comprend des valeurs différentielles des tensions d'accord variées des circuits d'accord par rapport aux valeurs de la tension d'accord du circuit oscillateur local du sélecteur de canaux,
**caractérisé en ce que**
N est un nombre supérieur à trois, en particulier cinq,
dans lequel ledit procédé est appliqué à un sélecteur de canaux dans lequel lesdites bobines sont obtenues par un procédé d'impression, et toutes lesdites bobines imprimées sont comprises dans le même circuit imprimé.

2. Procédé d'étalonnage selon la revendication 1, **caractérisé en ce que** ledit étalonnage est réalisé en corrigeant les tensions appliquées auxdites diodes varactor en partant de ladite information mise en mémoire qui est une information numérique, convertie par l'intermédiaire de convertisseurs numériques/analogiques.

3. Procédé d'étalonnage selon la revendication 1 ou 2, **caractérisé en ce que** ledit étalonnage est réalisée en corrigeant les tensions appliquées auxdites diodes varactor de façon à obtenir une réponse à signal maximum.

4. Procédé d'étalonnage selon la revendication 3, **caractérisé en ce que** ledit étalonnage est réalisé de façon à obtenir une réponse à signal maximum à la fréquence centrale du canal.

5. Procédé d'étalonnage selon la revendication 3, **caractérisé en ce que** ledit étalonnage est réalisé de façon à obtenir une réponse à signal maximum de la fréquence porteuse vidéo du canal.

6. Procédé d'étalonnage selon la revendication 3, **caractérisé en ce que** ledit étalonnage est réalisé de façon à obtenir un compromis de la réponse de signaux de la fréquence porteuse vidéo et de la fréquence porteuse audio du canal.

7. Procédé d'étalonnage selon l'une ou plusieurs des revendications précédentes, **caractérisé en ce que**, au cours de l'accord d'un signal radioélectrique à recevoir, ladite information mise en mémoire dans une mémoire (M) de type numérique est re-lue et est utilisée pour corriger la tension appliquée auxdites diodes varactor.

8. Procédé d'étalonnage selon l'une ou plusieurs des revendications précédentes, **caractérisé en ce que**, pendant le réglage fin d'un signal radioélectrique à recevoir, ladite information mise en mémoire dans une mémoire (M) de type numérique, est re-lue et est utilisée pour corriger la tension appliquée auxdites diodes varactor et **en ce que**, pour les canaux pour lesquels l'étalonnage n'a pas été réalisé, on utilise l'information mise en mémoire pour le canal étalonné le plus proche.

9. Procédé d'étalonnage selon l'une ou plusieurs des revendications précédentes, **caractérisé en ce que**, pendant le réglage fin d'un signal radioélectrique à recevoir, ladite information mise en mémoire dans une mémoire (M) de type numérique, est re-lue et est utilisée pour corriger la tension appliquée auxdites diodes varactor et **en ce que** pour les canaux pour lesquels l'étalonnage n'a pas été réalisé, on effectue l'interpolation de l'information mise en mémoire pour les deux canaux étalonnés les plus proches.

10. Procédé d'étalonnage selon l'une ou plusieurs des revendications précédentes, **caractérisé en ce que** ladite mise en mémoire de l'information d'étalonnage dans une mémoire (M) de type numérique, est réalisée automatiquement.

11. Récepteur de signal de télévision comprenant un sélecteur de canaux électronique avec une pluralité de circuits de sélection ou d'accord, dont l'un fait partie d'un oscillateur local, chaque circuit d'accord comprenant une diode varactor et des bobines, dans lequel :
- l'étalonnage est réalisé uniquement sur un canal tous les N canaux en variant les tensions d'accord fournies aux diodes varactor, et sans réglage desdites bobines, mais en cherchant uniquement les meilleures valeurs de tension d'étalonnage desdites tensions d'accord variées;
- l'information appropriée concernant les valeurs de tensions d'étalonnage est mise en mémoire dans un dispositif de stockage qui est associé au sélecteur de canaux ;
- l'étalonnage n'est pas fourni pour les tensions d'accord à fournir aux diodes varactor du circuit d'oscillateur local du sélecteur de canaux,
- ladite information mise en mémoire comprend des valeurs différentielles des tensions d'accord variées des circuits d'accord par rapport aux valeurs de la tension d'accord du circuit oscillateur local du sélecteur de canaux
**caractérisé en ce que**
lesdites bobines sont obtenues par un procédé d'impression,
toutes lesdites bobines imprimées sont comprises dans le même circuit imprimé, et N est un nombre supérieur à trois, en particulier cinq.

12. Récepteur de signal de télévision selon la revendication 11, **caractérisé en ce que** lesdites bobines imprimées sont réalisées sous la forme de spirales rondes concentriques.
